# EUROPÄISCHE PATENTANMELDUNG

(11) **EP 2 765 617 A2**
(43) Veröffentlichungstag der Anmeldung: **13.08.2014**
(21) Anmeldenummer: 14151363.0
(22) Anmeldetag: 16.01.2014
(51) Int. Cl.: H01L 31/18

(54) **Verfahren zum Herstellen von Wafern, insbesondere von Wafern für Solarzellen, und Vorrichtung zum Herstellen von Wafern**

(30) Priorität: 07.02.2013 DE 102013202028
(71) Anmelder: ROBERT BOSCH GMBH, 70442 Stuttgart (DE)
(72) Erfinder: Puzik, Arnold, 75392 Deckenpfronn (DE); Schoepf, Martin, 70499 Stuttgart (DE); Kuntzer, Michael, 71706 Markgroeningen (DE); Albrecht, Andreas, 73733 Esslingen (DE); Derhardt, Steffen, 70839 Gerlingen (DE)

(57) **Zusammenfassung**

Die Erfindung betrifft ein Verfahren zum Herstellen von Wafern (100), insbesondere von Wafern (100) für Solarzellen, bei dem ein blockförmiger Wafergrundkörper (10) an einem Trägerelement (20) befestigt wird und der Wafergrundkörper (10) von der dem Trägerelement (20) abgewandten Seite her mittels einer Trenneinrichtung (25), insbesondere mittels einer Drahtsäge, in die scheibenförmigen Wafer (100) aufgeteilt wird. Erfindungsgemäß ist es vorgesehen, dass der Wafergrundkörper (10) mittels einer klebstofffreien Verbindungstechnik kraft- und/oder formschlüssig an dem Trägerelement (20) befestigt wird.

## Beschreibung

### Stand der Technik

Die Erfindung betrifft ein Verfahren zum Herstellen von Wafern, insbesondere von Wafern für Solarzellen, nach dem Oberbegriff des Anspruchs 1. Ferner betrifft die Erfindung eine Vorrichtung zum Herstellen von Wafern.

Ein Verfahren nach dem Oberbegriff des Anspruchs 1 ist aus dem Stand der Technik bereits allgemein bekannt, und wird bei der Produktion von Wafern für Solarzellen angewandt. Bei dem bekannten Verfahren ist es vorgesehen, dass ein vorgefertigter, aus Silizium bestehender blockförmiger Wafergrundkörper unter Zwischenlage einer insbesondere aus Glas bestehenden Verlust- bzw. Opferplatte an einem als Werkzeugplatte ausgebildeten Trägerelement befestigt wird. Die Werkzeugplatte kann wiederum am Werkzeugtisch einer Bearbeitungsmaschine befestigt werden. Die Befestigung zwischen dem Wafergrundkörper, der Opferplatte und der Werkzeugplatte erfolgt über zwei Klebstoffschichten, die beidseitig der Opferplatte auf der dem Wafergrundkörper bzw. der Werkzeugplatte zugewandten Seite angeordnet sind. Ein derartig an einer Werkzeugplatte befestigter Wafergrundkörper wird anschließend von der der Werkzeugplatte abgewandten Seite her mittels einer insbesondere als Drahtsäge ausgebildeten Trenneinrichtung in scheibenförmige Wafer unterteilt bzw. zersägt, wobei die Trenneinrichtung den Wafergrundkörper über dessen gesamte Höhe zersägt und die Schnitte der Drahtsäge bis in die Opferplatte hinein ausgeführt werden. Anschließend werden die durch die Trenneinrichtung vereinzelten, und durch die Opferplatte noch zusammenhängenden Wafer von dem Wafergrundkörper bzw. der Opferplatte getrennt, indem der Wafergrundkörper zusammen mit der Opferplatte in ein Bad mit heißem Wasser oder verdünnter Säure angeordnet wird. Wichtig dabei ist, dass der Klebstoff das Ablösebad und das Silizium nicht verunreinigt, sondern an der Verlustplatte anhaften bleibt. Nachteilig bei dem aus dem Stand der Technik bekannten Verfahren ist es, dass das Handling zum Trennen der einzelnen Wafer von dem Wafergrundkörper durch die Notwendigkeit des Bades mit den darin enthaltenen Stoffen relativ aufwändig ist. Darüber hinaus wird als nachteilhaft angesehen, dass durch die Befestigung des Wafergrundkörpers über die beiden Klebschichten, die beidseitig der Opferplatte angeordnet sind, Positionsungenauigkeiten beim (senkrechten) Positionieren des Wafergrundkörpers zur Werkzeugplatte auftreten können, die in einer nicht winkligen bzw. nicht senkrechten Anordnung des Wafergrundkörpers zur Werkzeugplatte führen. Dadurch werden Ungenauigkeiten in der Geometrie der einzelnen Wafer beim Vereinzeln der Wafer aus dem Wafergrundkörper erzeugt, die entweder zu einem erhöhten Ausschuss oder, falls wirtschaftlich sinnvoll, ggf. zu nicht erwünschten Nachbearbeitungen führen.

### Offenbarung der Erfindung

Ausgehend von dem dargestellten Stand der Technik liegt der Erfindung die Aufgabe zugrunde, ein Verfahren zum Herstellen von Wafern, insbesondere von Wafern für Solarzellen, nach dem Oberbegriff des Anspruchs 1 derart weiterzubilden, dass ein vereinfachtes Handling bei gleichzeitig besonders guter Positioniergenauigkeit des Wafergrundkörpers zum Trägerelement ermöglicht wird. Diese Aufgabe wird erfindungsgemäß bei einem Verfahren zum Herstellen von Wafern mit den Merkmalen des Anspruchs 1 dadurch gelöst, dass der Wafergrundkörper mittels einer klebstofffreien Verbindungstechnik kraft- und/oder formschlüssig an dem Trägerelement befestigt wird. Als Trägerelement wird dabei im Rahmen der Erfindung jedes Element verstanden, das dazu geeignet ist, den Wafergrundkörper für eine Ausbildung der Wafer an einer geeigneten Werkzeugmachine zu befestigen. Der Begriff Trägerelement soll daher keinesfalls auf plattenförmige Elemente beschränkt sein. Diese Abkehr von der aus dem Stand der Technik bekannten Verbindungstechnik unter Verwendung von Klebstoff bewirkt, dass insbesondere Positionierungenauigkeiten, die durch unterschiedliche Schichtdicken des Klebstoffs bzw. Positionierfehler des Wafergrundkörpers zum Trägerelement und/oder zur Opferplatte entstehen können, prinzipiell vermieden werden. Darüber hinaus wird das Handling wesentlich vereinfacht, da auf den Einsatz von Flüssigkeiten bzw. Chemikalien enthaltenden Bädern zum Vereinzeln der Wafer von dem Wafergrundkörper verzichtet werden kann.

Vorteilhafte Weiterbildungen des erfindungsgemäßen Verfahrens sind in den Unteransprüchen aufgeführt.

Besonders bevorzugt ist es, wenn die klebstofffreie Verbindungstechnik in Form einer mechanisch oder pneumatisch wirkenden Spanneinrichtung oder eines Spannelements, insbesondere in Form einer Schraube, ausgebildet ist, die bzw. das unmittelbar mit dem Wafergrundkörper in Wirkverbindung angeordnet ist. Eine derartige Ausbildung ermöglicht es insbesondere, auf zusätzliche, den Herstellungsprozess verteuernde und das Handling erschwerende Zwischenschritte wie beim Stand der Technik (Befestigung einer Verlustplatte an einem Wafergrundkörper) zu verzichten. Wesentlich ist lediglich, dass durch die mechanisch oder pneumatisch wirkende Spanneinrichtung bzw. das Spannelement, die/das form- und/oder kraftschlüssig wirkt, eine sichere Befestigung des Wafergrundkörpers an dem Trägerelement ermöglicht wird, wobei die Befestigung einerseits die beim Ausbilden der scheibenförmigen Wafer auf den Wafergrundkörper wirkenden Kräfte aufnehmen muss und gleichzeitig unter allen Bedingungen eine lagerichtige Positionierung des Wafergrundkörpers zum Trägerelement ermöglichen soll.

In einer besonders bevorzugten Ausgestaltung der zuletzt vorgeschlagenen Verbindungstechnik wird vorgeschlagen, dass die Spanneinrichtung bzw. das Spannelement mit wenigstens einer in dem Wafergrundkörper ausgebildeten Fläche oder Ausnehmung zusammenwirkt. Eine derartige Ausnehmung kann beispielsweise in Form einer nutsteinförmigen Ausnehmung, einer Gewindebohrung, eines Schlitzes oder Ähnlichem ausgebildet sein, in die ein der Form der Ausnehmung angepasstes Halteelement der Spanneinrichtung eingreift, die wiederum mit dem Trägerelement verbunden ist. Durch eine entsprechende Anzahl und/oder Positionierung der Ausnehmungen an dem Wafergrundkörper wird dabei eine sichere und gleichmäßige Anlage des Wafergrundkörpers an dem Trägerelement ermöglicht.

Um die erfindungsgemäße klebstofffreie Verbindungstechnik zwischen dem Wafergrundkörper und dem Trägerelement zu ermöglichen, ist es insbesondere vorgesehen, dass der Wafergrundkörper einen Nutzbereich aufweist, der zur Ausbildung der scheibenförmigen Wafern dient, und dass sich an den Nutzbereich auf der dem Trägerelement zugewandten Seite ein Haltebereich des Wafergrundkörpers anschließt. In diesem Haltebereich sind dann, wie eben erläutert, die Ausnehmungen zur form- und/oder kraftschlüssigen Verbindung des Wafergrundkörpers an dem Trägerelement ausgebildet, oder aber der Haltebereich umfasst beispielsweise eine plane Anlagefläche für einen pneumatisch wirkenden Sauger, über den der Wafergrundkörper mit dem Trägerelement befestigt ist. In der Praxis lässt sich der Haltebereich in seiner Größe derart auslegen, dass gegenüber dem Stand der Technik zur Fertigung einer bestimmten Anzahl und/oder Größe von Wafern kein vergrößerter Wafergrundkörper erforderlich ist.

Um bei einem bestimmten Volumen bzw. einer bestimmten Höhe des Wafergrundkörpers eine möglichst große Größe der Wafer, d.h. möglichst wenig Produktverlust, erzielen zu können, ist es bei der zuletzt genannten Ausbildung des Wafergrundkörpers mit einem Nutzbereich und einem Haltebereich bevorzugt vorgesehen, dass die Trenneinrichtung beim Ausbilden der Wafer bis unmittelbar an den Bereich des Haltebereichs des Wafergrundkörpers bewegt wird. Dadurch wird die maximal mögliche Höhe des Wafergrundkörpers zur Erzeugung der Wafer ausgenützt.

Ein besonders einfacher bzw. wirtschaftlicher Trennprozess der Wafer von dem Wafergrundkörper wird erzielt, wenn das Vereinzeln der Wafer aus dem Wafergrundkörper durch einen Trennprozess erfolgt, der das Durchtrennen des Wafergrundkörpers im Bereich der Stirnseiten der Wafer in einer Richtung senkrecht zu den Wafern umfasst.

Ganz besonders bevorzugt ist es dabei, wenn das Vereinzeln durch die Trenneinrichtung erfolgt, die auch zum Ausbilden der Wafer aus dem Wafergrundkörper dient. Dadurch wird ein besonders einfaches Handling erzielt, bei dem es lediglich erforderlich ist, die Trenneinrichtung in einer Ebene parallel zu dem Trägerelement zu bewegen, um die Wafer von dem Wafergrundkörper zu trennen.

Es kann jedoch auch vorgesehen sein, dass das Vereinzeln durch eine von der Trenneinrichtung zum Ausbilden der Wafer aus dem Wafergrundkörper unterschiedliche Vereinzelungseinrichtung erfolgt. Ein derartiges Vorgehen ermöglicht es, für den jeweiligen Arbeitsgang (Ausbilden von scheibenförmigen Wafern aus dem Wafergrundkörper sowie dazu senkrechtes Abtrennen der Wafer von dem Wafergrundkörper) optimierte Trenneinrichtungen einzusetzen, die beispielsweise besonders hohe Oberflächenqualitäten an den jeweiligen Schnittkanten ermöglichen bzw. besonders effektive, d.h. schnelle Schnitte möglich machen.

Zum Abtrennen der Wafer von dem Wafergrundkörper kann es bei der zuletzt genannten Ausgestaltung der Erfindung vorgesehen sein, dass das Abtrennen durch einen elektrochemischen Materialabtrag erfolgt. In diesem Fall wird der Wafergrundkörper in einer Elektrolytflüssigkeit angeordnet, wobei der Wafergrundkörper mit dem einen Pol einer Spannungsquelle, und die Vereinzelungseinrichtung (beispielsweise in Form von Drähten) mit dem anderen Pol der Spannungsquelle verbunden wird.

Die Erfindung umfasst auch eine Vorrichtung zum Herstellen von Wafern (100), insbesondere zum Durchführen des erfindungsgemäßen Verfahrens, wobei ein Trägerelement vorgesehen ist, an dem ein Wafergrundkörper befestigbar ist. Dabei ist es erfindungsgemäß vorgesehen, dass an dem Trägerelement eine mechanisch oder pneumatisch wirkende Spanneinrichtung oder ein Spannelement angeordnet ist. Eine derartige Spanneinrichtung kann beispielsweise in Form von aus dem Maschinenbau an sich bekannten Spannpratzen oder Ähnlichem oder in Form eines oder mehrerer Sauger bestehen. Ein Spannelement kann zum Beispiel als Befestigungsschraube o.ä. ausgebildet sein.

Weitere Vorteile, Merkmale und Einzelheiten der Erfindung ergeben sich aus der nachfolgenden Beschreibung bevorzugter Ausführungsbeispiele sowie anhand der Zeichnung.

Diese zeigt in:
- Fig. 1: eine perspektivische Darstellung eines Siliziumblockes, wie er zur Herstellung eines Wafergrundkörpers verwendet wird,
- Fig. 2: einen Querschnitt durch einen Wafergrundkörper vor dem Abtrennen der einzelnen Wafer von dem Wafergrundkörper,
- Fig. 3 bis Fig. 5: jeweils Teilquerschnitte durch einen Wafergrundkörper im Haltebereich des Wafergrundkörpers mit unterschiedlich ausgebildeten Aufnahmen zur Befestigung des Wafergrundkörpers an einer Werkzeugplatte,
- Fig. 6: eine perspektivische Teilansicht auf einen Wafergrundkörper mit nutförmigen Ausnehmungen,
- Fig. 7 und Fig. 8: jeweils Teilquerschnitte durch einen Wafergrundkörper mit unterschiedlich ausgebildeten schlitz- bzw. nutförmigen Ausnehmungen zur Befestigung des Wafergrundkörpers an einer Werkzeugplatte,
- Fig. 9 und Fig. 10: Querschnitte im Bereich eines Wafergrundkörpers sowie einer Spanneinrichtung für den Wafergrundkörper gemäß Fig. 9 und
- Fig. 11: eine Seitenansicht auf einen Wafergrundkörper, der mittels einer pneumatischen Halteeinrichtung an einer Werkzeugplatte gehalten ist.

Gleiche Elemente bzw. Elemente mit gleicher Funktion sind in den Figuren mit den gleichen Bezugsziffern versehen.

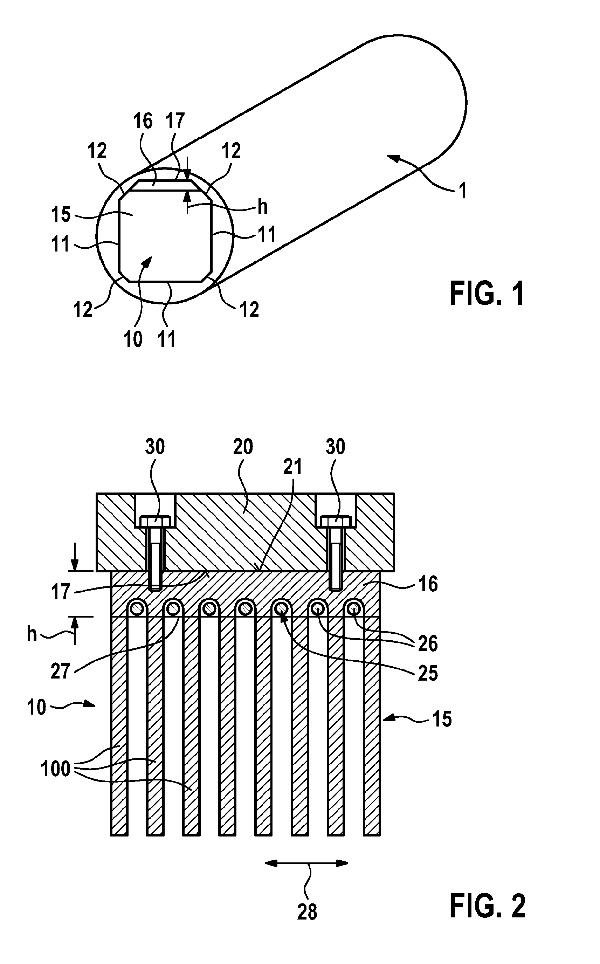

In der Fig. 1 ist ein aus Silizium bestehender Gussblock 1 in Form eines einen runden Querschnitt aufweisenden Zylinders dargestellt. Innerhalb des Querschnitts des Gussblocks 1 ist der Querschnitt eines blockförmigen Wafergrundkörpers 10 erkennbar, der im Wesentlichen einen rechteckförmigen Querschnitt mit vier geraden Seitenflächen 11 und gerundeten bzw. abgeschrägten Ecken 12 aufweist. Der soweit beschriebene Querschnitt des Wafergrundkörpers 10 bildet einen Nutzbereich 15 aus, der zur Ausbildung von scheibenförmigen Wafern 100 benutzt wird, die insbesondere der Fertigung von Solarzellen dienen. An einer Seitenfläche 11 des Nutzbereichs 15 schließt sich ein Haltebereich 16 mit einer Höhe h an, wobei die der Seitenfläche 11 abgewandte ebene Begrenzungsfläche 17, die parallel zur Seitenfläche 11 verläuft, als Befestigungsfläche an ein in der Fig. 2 erkennbares Trägerelement in Form einer Werkzeugplatte 20 dient. Der Wafergrundkörper 10, bestehend aus dem Nutzbereich 15 und dem Haltebereich 16 wird insbesondere durch eine als Säge ausgebildete Einrichtung aus dem Gussblock 1 gebildet (nicht dargestellt).

In der Fig. 2 ist der soweit beschriebene Wafergrundkörper 10 mit der ebenen Begrenzungsfläche 17 gegen die ebenfalls ebene Anlagefläche 21 der Werkzeugplatte 20 festgelegt. In der Fig. 2 ist dabei der Zustand dargestellt, der sich am Ende einer Bearbeitung des Wafergrundkörpers 10 einstellt, bei der eine Trenneinrichtung 25 in Form einer Drahtsäge mit einer Vielzahl von parallel zueinander angeordneten Einzeldrähten 26 von der der Werkzeugplatte 20 abgewandten Seite des Wafergrundkörpers 10 senkrecht zur Ebene der Werkzeugplatte 20 bzw. der Anlagefläche 21 führende Sägeschnitte ausgeführt hat, sodass eine Vielzahl von parallel zueinander angeordneten Wafern 100 in dem Wafergrundkörper 10, insbesondere in dem Nutzbereich 15 des Wafergrundkörpers 10, ausgebildet werden.

Durch die Begrenzungslinie 27 ist in der Fig. 2 der Übergang von dem Nutzbereich 15 in den Haltebereich 16 des Wafergrundkörpers 10 gekennzeichnet. Man erkennt, dass die Einzeldrähte 26 der Trenneinrichtung 25 bis in den Haltebereich 15 geführt wurden. Das Abtrennen der einzelnen Wafer 100 von dem Wafergrundkörper 10 erfolgt anschließend durch eine Relativbewegung zwischen der Trenneinrichtung 25 bzw. den Einzeldrähten 26 und dem Wafergrundkörper 10 in einer Ebene parallel zur Anlagefläche 21 der Werkzeugplatte 20 entsprechend der Richtung des Doppelpfeils 28. Die Trennebene bildet dabei die einen Seitenflächen der Wafer 100 aus. Erfindungsgemäß ist es vorgesehen, dass die Befestigung des Wafergrundkörpers 10 über den Haltebereich 16 an der Anlagefläche 21 der Werkzeugplatte 20 mittels einer klebstofffreien Verbindungstechnik erfolgt. Eine derartige Verbindungstechnik ist dabei im Rahmen der Erfindung als form- und/oder kraftschlüssige Verbindungstechnik ausgebildet.

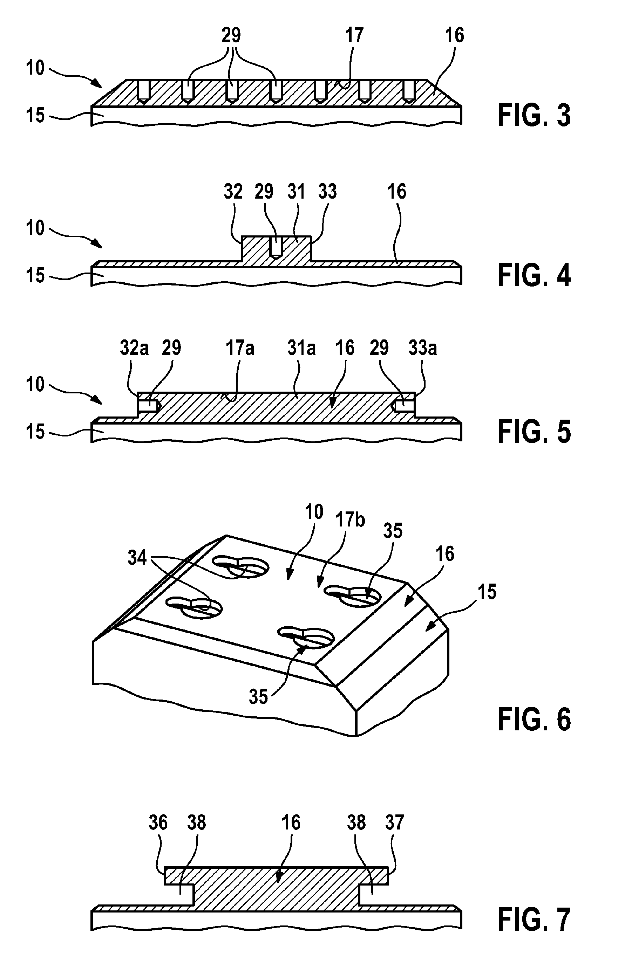

Ein erstes Ausführungsbeispiel dieser Verbindungstechnik ist anhand der der Fig. 2 und 3 dargestellt, aus der erkennbar ist, dass in dem Haltebereich 16 des Wafergrundkörpers 10 eine Vielzahl von parallel zueinander angeordneten Ausnehmungen in Form von Gewindebohrungen 29 vorgesehen sind, die sich senkrecht zur Begrenzungsfläche 17 bzw. zur Anlagefläche 21 der Werkzeugplatte 20 erstrecken. Durch eine entsprechende Ausgestaltung der Anlagefläche 21 der Werkzeugplatte 20, die eine Befestigung von Spannelementen, insbesondere in Form von Schrauben 30 ermöglicht, kann der Wafergrundkörper 10 somit mit seiner Begrenzungsfläche 17 unmittelbar gegen die Anlagefläche 21 des Trägerelements bzw. der Werkzeugplatte 20 verspannt und positioniert werden.

In der Fig. 4 ist der Haltebereich 16 in Form eines über die gesamte Länge des Wafergrundkörpers 10 sich erstreckenden Haltesteges 31 ausgebildet, in dem beispielsweise mehrere, senkrecht zur Zeichenebene der Fig. 4 ausgebildete Gewindebohrungen 29 ausgebildet sind. Der Haltesteg 31 weist zwei gegenüberliegend angeordnete Seitenflächen 32, 33 auf, die beispielsweise dazu genutzt werden können, in Wirkverbindung mit einer entsprechenden nutförmigen Aufnahme der Werkzeugplatte 20 angeordnet zu werden, um den Wafergrundkörper 10 zur Werkzeugplatte 20 bzw. zu dessen Anlagefläche 21 zu positionieren.

In der Fig. 5 ist eine gegenüber der Fig. 4 abgewandelte Ausführungsform der Erfindung dargestellt, bei der der Haltesteg 31a seitlich bis an den (runden) Grundquerschnitt des Gussblocks 1 heranreicht. An gegenüberliegenden Halteflächen 32a, 33a sind Gewindebohrungen 29 ausgebildet, die parallel zur Begrenzungsfläche 17a des Wafergrundkörpers 10 verlaufen.

In der Fig. 6 ist eine weitere Ausführungsform der Erfindung dargestellt, bei der in der Begrenzungsfläche 17b des Wafergrundkörpers 10 bzw. des Haltebereichs 16 des Wafergrundkörpers 10 vier, jeweils einen Hinterschnitt 34 aufweisende Ausnehmungen 35 ausgebildet sind. Über die Hinterschnitte 34 der Ausnehmungen 35 lässt sich der Wafergrundkörper 10 über entsprechende Gegenelemente form- bzw. kraftschlüssig an der Anlagefläche 21 der Werkzeugplatte 20 befestigen.

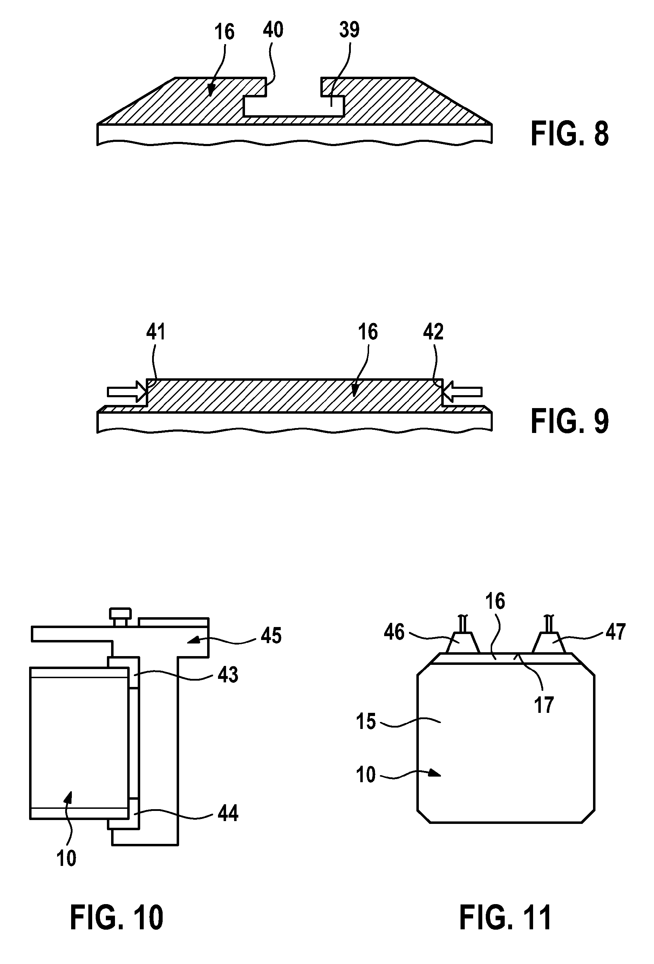

In den Fig. 7 und 8 sind modifizierte Haltebereiche 16 eines Wafergrundkörpers 10 dargestellt. In der Fig. 7 weist der Haltebereich 16 an gegenüberliegend angeordneten Seitenflächen 36, 37 jeweils einen rechteckförmigen Querschnitt aufweisende Haltenuten 38 auf, über die der Wafergrundkörper 10 beispielsweise mittels Haltepratzen an der Werkzeugplatte 20 bzw. der Anlagefläche 21 unmittelbar befestigt werden kann. Bei dem Ausführungsbeispiel gemäß der Fig. 8 ist mittig in dem Haltebereich 16 eine einen Hinterschnitt 39 aufweisende Befestigungsnut 40 vorgesehen, über die mittels entsprechender Nutsteine der Wafergrundkörper 10 an der Werkzeugplatte 20 befestigt werden kann.

In den Fig. 9 und 10 ist eine Ausführungsform der Erfindung dargestellt, bei der der Wafergrundkörper 10 an gegenüberliegenden Seitenflächen 41, 42 des Haltebereichs 16 mittels einer in der Fig. 10 dargestellten, im Querschnitt L-förmige Winkel 43, 44 aufweisenden Spanneinrichtung 45 an der Werkzeugplatte 20 befestigt werden kann.

Zuletzt ist in der Fig. 11 eine Ausführungsform der Erfindung dargestellt, bei der die ebene Begrenzungsfläche 17 des Haltebereichs 16 als Anlage für zwei pneumatisch arbeitende Sauger 46, 47 dient, die wiederum an der Werkzeugplatte 20 bzw. Anlagefläche 21 befestigbar sind.

Die Werkzeugplatte 20 als Trägerelement ist zusammen mit der mechanisch oder pneumatisch wirkenden Spanneinrichtung 45, 46, 47 oder dem Spannelement 30 Teil einer Vorrichtung zum Herstellen von Wafern 100.

Das soweit beschriebene Verfahren zur Befestigung eines Wafergrundkörpers 10 an einem insbesondere als Werkzeugplatte 20 ausgebildeten Trägerelement kann in vielfältiger Art und Weise abgewandelt bzw. modifiziert werden, ohne vom Erfindungsgedanken abzuweichen. Wesentlich ist lediglich, dass die Verbindung bzw. Befestigung des Wafergrundkörpers 10 über eine form- und/oder kraftschlüssige Verbindungstechnik erfolgt, bei der die Verwendung von Klebstoffen nicht erforderlich ist.

## Patentansprüche

1. Verfahren zum Herstellen von Wafern (100), insbesondere von Wafern (100) für Solarzellen, bei dem ein blockförmiger Wafergrundkörper (10) an einem Trägerelement (20) befestigt wird und der Wafergrundkörper (10) von der dem Trägerelement (20) abgewandten Seite her mittels einer Trenneinrichtung (25), insbesondere mittels einer Drahtsäge, in scheibenförmige Wafer (100) aufgeteilt wird,
**dadurch gekennzeichnet,**
**dass** der Wafergrundkörper (10) mittels einer klebstofffreien Verbindungstechnik kraft- und/oder formschlüssig an dem Trägerelement (20) befestigt wird.

2. Verfahren nach Anspruch 1,
**dadurch gekennzeichnet,**
**dass** die Verbindungstechnik eine mechanisch oder pneumatisch wirkende Spanneinrichtung (45; 46, 47) oder ein Spannelement (30), insbesondere in Form einer Schraube, umfasst, die bzw. das unmittelbar mit dem Wafergrundkörper (10) in Wirkverbindung angeordnet ist.

3. Verfahren nach Anspruch 2,
**dadurch gekennzeichnet,**
**dass** die Spanneinrichtung (45) bzw. das Spannelement (30) mit wenigstens einer in dem Wafergrundkörper (10) ausgebildeten Fläche (41, 42) oder Ausnehmung (29; 35; 38; 40) zusammenwirkt.

4. Verfahren nach einem der Ansprüche 1 bis 3,
**dadurch gekennzeichnet,**
**dass** der Wafergrundkörper (10) einen Nutzbereich (15) aufweist, der zur Ausbildung der scheibenförmigen Wafer (100) dient, und dass sich an den Nutzbereich (15) auf der dem Trägerelement (20) zugewandten Seite ein Haltebereich (16) des Wafergrundkörpers (10) anschließt.

5. Verfahren nach Anspruch 4,
**dadurch gekennzeichnet,**
**dass** die Trenneinrichtung (25) beim Ausbilden der Wafer (100) bis in den Haltebereich (16) des Wafergrundkörpers (10) bewegt wird.

6. Verfahren nach einem der Ansprüche 1 bis 5,
**dadurch gekennzeichnet,**
**dass** das Vereinzeln der Wafer (100) aus dem Wafergrundkörper (10) durch einen Trennprozess erfolgt, der das Durchtrennen des Wafergrundkörpers (10) im Bereich der Stirnseiten der Wafer (100) in einer Richtung senkrecht zu den Wafern (100) umfasst.

7. Verfahren nach Anspruch 6,
**dadurch gekennzeichnet,**
**dass** das Vereinzeln der Wafer (100) durch die Trenneinrichtung (25) erfolgt, die auch zum Ausbilden der Wafer (100) aus dem Wafergrundkörper (10) verwendet wird.

8. Verfahren nach Anspruch 6,
**dadurch gekennzeichnet,**
**dass** das Vereinzeln der Wafer (100) durch eine von der Trenneinrichtung (25) zum Ausbilden der Wafer (100) aus dem Wafergrundkörper (10) unterschiedliche Vereinzelungseinrichtung erfolgt.

9. Verfahren nach Anspruch 8,
**dadurch gekennzeichnet,**
**dass** die Vereinzelung der Wafer (100) durch einen elektrochemischen Materialabtrag erfolgt.

10. Vorrichtung zum Herstellen von Wafern (100), insbesondere zum Durchführen eines Verfahrens nach einem der Ansprüche 1 bis 9, mit einem Trägerelement (20), an dem ein Wafergrundkörper (10) befestigbar ist,
**dadurch gekennzeichnet,**
**dass** an dem Trägerelement (20) eine mechanisch oder pneumatisch wirkende Spanneinrichtung (45; 46, 47) oder ein Spannelement (30) angeordnet ist.
